# EUROPEAN PATENT SPECIFICATION

(11) **EP 1 973 168 B1**
(45) Date of publication and mention of the grant of the patent: **04.06.2014**
(21) Application number: 08250951.4
(22) Date of filing: 18.03.2008
(51) Int. Cl.: H01L 31/0352, H01L 31/068, H01L 31/075, H01L 21/304, B23K 26/00, B23K 26/08, B23K 26/40, H01L 31/076, H01L 31/0687

(54) **Method for manufacturing solar cell by fracturing along a dividing groove and the corresponding solar cell**
Verfahren zur Herstellung einer Solarzelle durch Brechen entlang einer Trennlinie und entsprechende Solarzelle
Procédé pour la fabrication d'une pile solaire par cassure le long une ligne de séparation et pile solaire ainsi fabriqué

(30) Priority: 20.03.2007 JP 2007073576
(43) Date of publication of application: 24.09.2008
(73) Proprietor: Sanyo Electric Co., Ltd., Osaka 570-8677 (JP)
(72) Inventor: Kannou, Hiroyuki, Moriguchi City Osaka 570-8677 (JP); Shima, Masaki, Moriguchi City Osaka 570-8677 (JP)
(74) Representative: Calderbank, Thomas Roger

(56) References cited:
- EP-A1- 1 480 277
- EP-A1- 1 770 791
- DE-A1- 10 347 647
- JP-A- 2001 094 127
- US-A- 4 089 705

## Description

The present invention relates to a method for manufacturing a solar cell fractured along a dividing groove, and to the solar cell.

A solar cell directly converts the sunlight, which is clean and supplied unlimitedly, into electricity. Hence, the solar cell is expected as a new energy source.

An output per one solar cell is no more than several watts. Hence, in the case of using the solar cell as a power source of a house, a building or the like, a solar cell module in which a plurality of the solar cells are electrically connected in series or parallel is used. The solar cell is fabricated by forming a semiconductor junction by using a polygonal semiconductor substrate processed from a circular semiconductor substrate.

It is known to process the circular solar cell into a regular hexagon having apexes on an outer circumference portion of the circular solar cell in order to increase a light receiving area of the solar cell module, and to enhance utilization efficiency of the circular semiconductor substrate (for example, refer to Japanese Patent Laid-Open No. H9-148610 (published in 1997)). In this case, a method is adopted, in which the circular solar cell is fractured along a regular hexagonal dividing groove having apexes on the outer circumference portion of the circular solar cell after the regular hexagonal dividing groove is formed by irradiating a laser beam onto the circular semiconductor substrate.

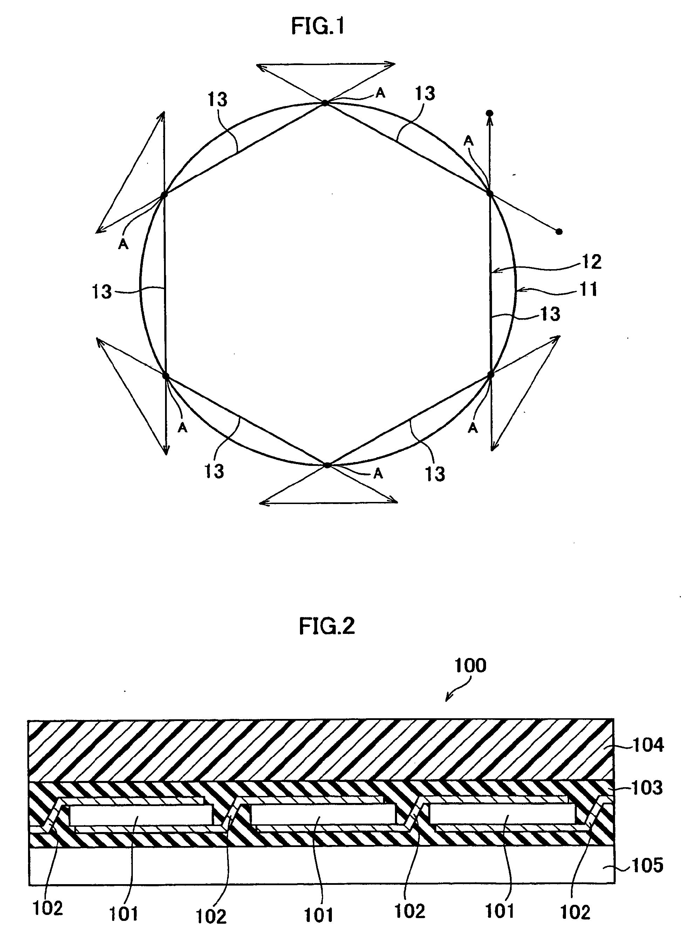

Here, it is desirable that the dividing groove be uniformly formed at a predetermined depth so as not to break the semiconductor junction which the circular solar cell includes. Hence, in the case of fabricating a regular hexagonal solar cell 12 by processing a circular solar cell 11 as shown in FIG. 1, a direction of the laser beam is changed on an outside of the circular solar cell 11 in order to uniformly form the dividing groove 13 at the predetermined depth.

However, since it is necessary to change the direction of the laser beam at all the apexes A in such a forming method of the dividing groove 13, there has been a problem that it takes long to perform the step of forming the dividing groove.

Moreover, since there is a tendency that many crystal faults are present on the outer circumference portion of the circular semiconductor substrate, there has been an apprehension that the regular hexagonal solar cell 12 formed by using the outer circumference portion (in the vicinities of the apexes A) of the circular semiconductor substrate cannot obtain good solar cell characteristics.

Furthermore, since the laser beam is irradiated twice onto the vicinities of the apexes A, there has been an apprehension that the semiconductor junction on side surface of the solar cell in the vicinities of the apexes A may be broken, bringing a decrease of the characteristics of the regular hexagonal solar cell 12.

US-A-4089705 discloses a method of manufacturing a solar cell panel, in which six non-contiguous segments are cut from a substrate on which the solar cell is formed, so that the solar cell has a hexagonal shape with rounded corners.

According to the present invention there is provided a method for manufacturing a solar cell, comprising:
forming a photoelectric conversion part that includes a semiconductor substrate;
forming collecting electrodes on the photoelectric conversion part;
forming a dividing groove that reaches the semiconductor substrate in a thickness direction of the photoelectric conversion part; and
fracturing the photoelectric conversion part along the dividing groove,
wherein the dividing groove is formed by a laser beam that repeats alternately a linear movement and a curved movement.

The present invention enables a method for manufacturing a solar cell to be used in which the dividing grooves are formed in a short time, so the solar cell characteristics are enhanced.

The dividing groove may be composed of linear grooves and curved grooves, and that a shortest distance between each of the curved grooves and the outer circumference portion of the photoelectric conversion part be smaller than a shortest distance between each of the linear grooves and the outer circumference portion of the photoelectric conversion part.

In the drawings:
Fig. 1 is a view for explaining a conventional step of forming dividing grooves.
Fig. 2 is a cross-sectional view of a solar cell module including solar cells according to an embodiment.
Fig. 3 is a cross-sectional view of a solar cell according to the embodiment.
Fig. 4 is a plan view of the solar cell according to the embodiment.
FIGS. 5A and 5B are views for explaining a method for manufacturing a solar cell according to the embodiment (No. 1).
FIGS. 6A and 6B are views for explaining the method for manufacturing a solar cell according to the embodiment (No. 2).
FIGS. 7A is a cross-sectional view of a portion α in FIG. 5B.
FIGS. 7B is a enlarged views of the portion α in FIG. 5B.

Next, a description will be made of embodiments of the present invention by using the drawings. In the following description of the drawings, the same or similar reference numerals are assigned to the same or similar portions. However, it should be noted that the drawings are schematic, and that ratios of the respective dimensions, and the like are different from actual ones. Hence, specific dimensions and the like should be determined in consideration for the following description. Moreover, it is a matter of course that portions in which mutual dimensional relationships and ratios are different among the drawings are incorporated therein.

### <Configuration of Solar Cell Module>

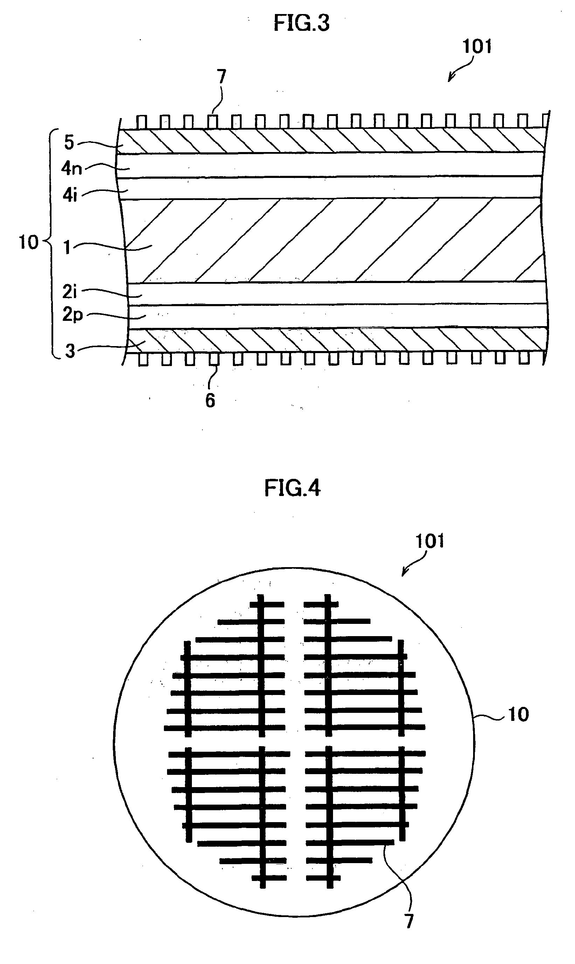

A description will be made of a configuration of a solar cell module 100 according to this embodiment by using FIG. 2 and FIG. 3. FIG. 2 is a cross-sectional view of the solar cell module 100 according to this embodiment. FIG. 2 is an enlarged cross-sectional view of each of solar cells 101 according to this embodiment. Note that, in FIG. 3, a lower surface is shown as a light receiving surface of the solar cell 101.

As shown in FIG. 2, the solar cell module 100 includes: the solar cells 101; wiring members 102; sealing member 103; a light receiving surface-side protection material 104; and a back surface-side protection material 105.

As shown in FIG. 3, the solar cell 101 includes: a photoelectric conversion part 10; light receiving surface-side collecting electrodes 6; and back surface-side collecting electrodes 7.

The photoelectric conversion part 10 generates carriers by receiving light. Each of the carriers refers to a pair of a hole and an electron, which is generated in such a manner that the light is absorbed to the photoelectric conversion part 10. The photoelectric conversion part 10 according to this embodiment has a semiconductor pin junction as a basic structure. Specifically, the photoelectric conversion part 10 includes an n-type single crystal silicon substrate 1, an i-type amorphous silicon layer 2i, a p-type amorphous silicon layer 2p, a transparent conductive film 3, an i-type amorphous silicon layer 4i, an n-type amorphous silicon layer 4n, and a transparent conductive film 5. On the light receiving surface (lower surface) side of the n-type single crystal silicon substrate 1, the i-type amorphous silicon layer 2i, the p-type amorphous silicon layer 2p, and the transparent conductive film 3 are sequentially stacked. Moreover, on the back surface (upper surface) side of the n-type single crystal silicon substrate 1, the i-type amorphous silicon layer 4i, the n-type amorphous silicon layer 4n, and the transparent conductive film 5 are sequentially stacked.

Here, on each of all side surfaces of the photoelectric conversion part 10 according to this embodiment, the n-type single crystal silicon substrate 1 includes a fractured surface (processed surface), which is fractured by bending the photoelectric conversion part 10 along dividing grooves formed by a laser beam. Specifically, on each of all side surfaces of the photoelectric conversion part 10, the n-type single crystal silicon substrate 1 is fractured. A form of portions among each of the side surfaces of the photoelectric conversion part 10, in which the dividing grooves are formed by the laser beam, exhibits a form in which the portions are coagulated after being fused.

The light receiving surface-side collecting electrodes 6 and the back surface-side collecting electrodes 7 collect photogenerated carriers generated in such a manner that the photoelectric conversion part 10 receives the light. The light receiving surface-side collecting electrodes 6 are formed into a comb shape on the light receiving surface of the transparent conductive film 3. The back surface-side collecting electrodes 7 are formed into a comb shape on a back surface of the transparent conductive film 5. Moreover, the light receiving surface-side collecting electrodes 6 and the back surface-side collecting electrodes 7 can be formed of one containing a conductive material such as silver, aluminum, copper, nickel, tin, gold, and alloys of these.

The solar cell module 100 including the solar cells 101 with such a configuration as described above is called an HIT solar cell module. The solar cells 101 are electrically connected to one another by the wiring members 102.

The sealing member 103 seal the plurality of solar cells 101 electrically connected to one another by the wiring members 102. The sealing member 103 can be formed by using a resin material such as ethylene vinyl acetate (EVA) and polyvinyl butyral (PVB).

The light receiving surface-side protection material 104 is composed by using a member that transmits therethrough much of light with wavelengths absorbable by the solar cells 101. Glass, plastics and the like can be used as the light receiving surface-side protection material 104.

The back surface-side protection material 105 is a film of resin such as polyethylene terephthalate (PET), a resin film on which an evaporated film of a metal oxide such as alumina is formed, a metal film such as aluminum foil, or a film formed by stacking these films.

### <Method for Manufacturing Solar Cell Module 100>

A description will be made of a method for manufacturing the solar cell module 100 according to this embodiment.

First, the circular n-type single crystal silicon substrate 1 obtained by thinly fracturing ingot-like n-type single crystal silicon is prepared, and a surface of the n-type single crystal silicon substrate 1 is subjected to an etching process, whereby minute irregularities are formed.

Next, the i-type amorphous silicon layer 2i and the p-type amorphous silicon layer 2p are sequentially stacked on the light receiving surface of the n-type single crystal silicon substrate 1 by using a vapor deposition method. In a similar way, the i-type amorphous silicon layer 4i and the n-type amorphous silicon layer 4n are sequentially stacked on the back surface of the n-type single crystal silicon substrate 1.

Next, by using a sputtering method, an ITO film (the transparent conductive film 3) is formed on the light receiving surface of the p-type amorphous silicon layer 2p. In a similar way, an ITO film (the transparent conductive film 5) is formed on the back surface of the n-type amorphous silicon layer 4n. In such a way, the circular photoelectric conversion part 10 that has the pin junction and uses the circular n-type single crystal silicon substrate 1 is formed.

Next, by using a printing method, a silver paste is formed into a comb shape on the light receiving surface of the ITO film (the transparent conductive film 3). In such a way, the light receiving surface-side collecting electrodes 6 are formed on the light receiving surface of the photoelectric conversion part 10. In a similar way, a silver paste is formed into a comb shape on the back surface of the ITO film (the transparent conductive film 3). In such a way, the back surface-side collecting electrodes 7 are formed on the back surface of the photoelectric conversion part 10. FIG. 4 shows the back surface-side collecting electrodes 7 formed on the back surface of the photoelectric conversion part 10. Note that, though not shown, the light receiving surface-side collecting electrodes 6 are formed substantially symmetrically to the back surface-side collecting electrodes 7 on the light receiving surface of the photoelectric conversion part 10.

Next, the silver pastes are heated under predetermined conditions. In such a way, the circular solar cell 101 is manufactured.

Next, in response to a pattern of the comb shape into which the back surface-side collecting electrodes 7 are formed, dividing grooves are formed on the back surface side of the circular solar cell 101 by using a YAG laser, and the circular solar cell 101 is fractured along the dividing grooves. In this embodiment, the circular solar cell 101 is fractured along the dividing grooves, and is thereby divided into four. Note that the step of forming the dividing grooves will be described later in detail.

Next, the light receiving surface-side collecting electrodes 6 formed on the light receiving surface of one solar cell 101 and the back surface-side collecting electrodes 7 formed on the other solar cell 101 adjacent thereto are electrically connected to each other by the wiring member 102.

Next, on a glass substrate (the light receiving surface-side protection material 104), an EVA sheet (the sealing member 103), the plurality of solar cells 101 connected to one another by the tabs, an EVA sheet (the sealing member 103), and a PET film (the back surface-side protection material 105) are sequentially stacked, and a stacked body is formed.

Next, the stacked body is temporarily pressed by being heated and pressed in a vacuum atmosphere, and is thereafter heated under predetermined conditions, whereby the EVA is crosslinked.

In such a way, the solar cell module 100 is manufactured. Note that a terminal box, an Al frame and the like can be attached onto the solar cell module 100.

### <Regarding Step of Forming Dividing Grooves>

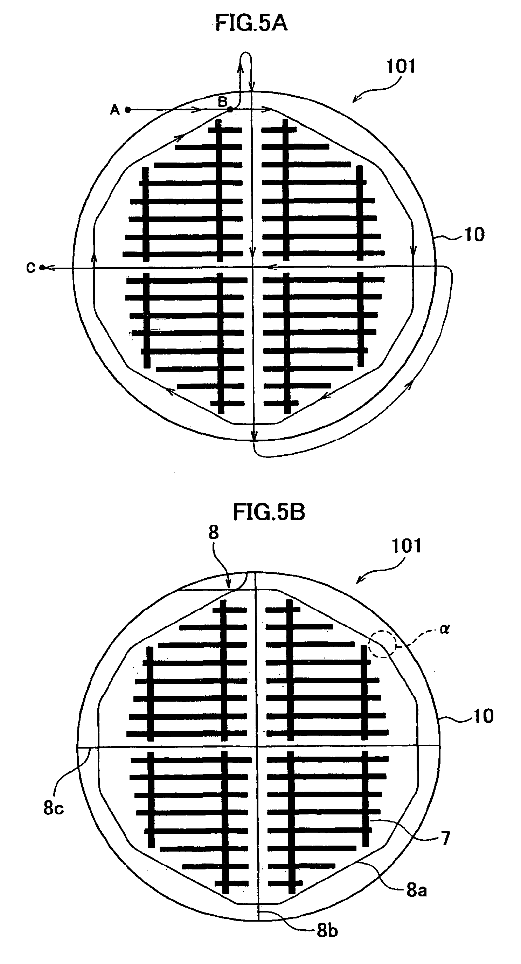

Next, by using the drawings, a description will be made of the step of forming the dividing grooves, which is related to the characteristic portions of the present invention. FIG. 5A shows an orbit of the laser beam irradiated onto the back surface of the circular solar cell 101 (the photoelectric conversion part 10). FIG. 5B shows the dividing grooves 8 formed on the back surface of the circular solar cell 101 (the photoelectric conversion part 10).

First, as shown in FIG. 5A, the laser beam is irradiated continuously from a point A to a point C, whereby the dividing grooves 8 are formed. Specifically, the laser beam is moved from the point A to a direction of a point B while being accelerated at an acceleration time constant of 10 to 50 mm/sec., and a moving speed of the laser beam is made to reach 300 mm/sec. until the laser beam reaches the point B. Subsequently, while substantially maintaining the moving speed at 300 mm/sec., the laser beam is made to go around an inside of an outer circumference portion of the solar cell 101, and is made to reach the point B again. In this case, a linear movement and curved movement of the laser beam are repeated alternately, whereby a direction of the laser beam is changed. In such a way, the dividing groove 8a composed of linear grooves and curved grooves is formed in the inside of the outer circumference portion of the solar cell 101.

Next, after the laser beam is moved once from the point B to the outside of the solar cell 101, the laser beam is moved while substantially maintaining the moving speed at 300 mm/sec. so as to pass through a central point of the solar cell 101. In such a way, the dividing groove 8b that divides the solar cell 101 into two is formed. Subsequently, after being moved by a quarter of the outer circumference portion of the solar cell 101 on the outside thereof, the laser beam 101 is moved so as to pass through the central point of the solar cell 101 one more time. In such a way, the dividing groove 8c that divides the solar cell 101 into two is formed.

The movement of the laser beam in the above-described step of forming the dividing grooves can be performed by moving an XY table to which the solar cell 101 is fixed, or by moving a laser beam oscillator. Moreover, the YAG laser can be used as the laser beam oscillator. As laser beam irradiation conditions of the YAG laser, a wavelength of a second harmonic can be set at 400 nm or more, a frequency can be set at 1 kHz to 50 kHz, a beam diameter can be set at 20 to 200 µm, and an output can be set at 1 to 25W. By using such laser beam irradiation conditions, the dividing grooves 8 which have a width substantially equal to the beam diameter of the laser beam are formed.

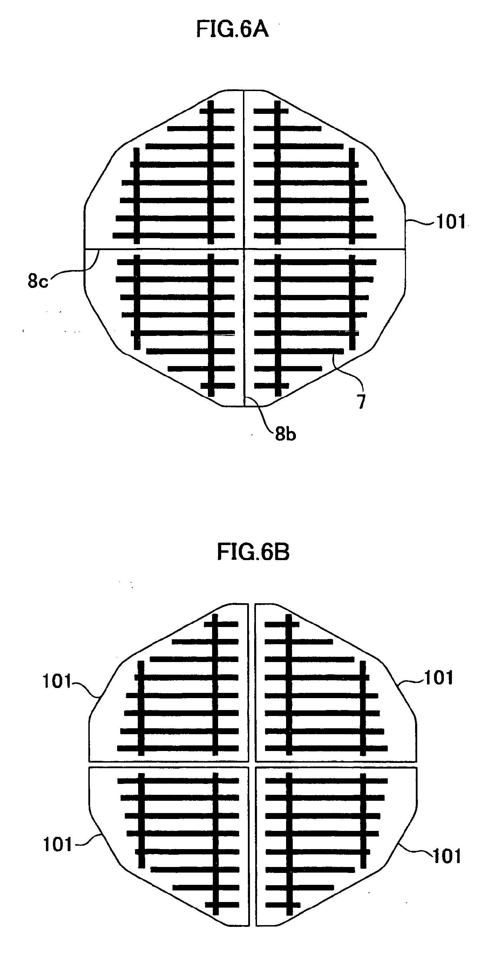

Thereafter, the solar cell 101 is bent along the dividing groove 8a, whereby the solar cell 101 is fractured along the dividing groove 8a. In such a way as shown in FIG. 6A, an outer portion of the dividing groove 8a formed in the inside of the outer circumference portion of the solar cell 101 is removed.

Next, the solar cell 101 is bent along the dividing grooves 8b and 8c, whereby the solar cell 101 is fractured along the dividing grooves 8b and 8c. In this case, there are no limitations on an order of bending the solar cell 101. For example, the solar cell 101 is fractured along the dividing groove 8b to be thereby divided into two, and thereafter, the respective divided pieces are fractured along the dividing groove 8c, whereby the solar cell 101 can be divided into four as shown in FIG. 6B.

### <Regarding Dividing Grooves 8>

As shown in FIG. 5B, the dividing groove 8a is formed continuously in the inside of the outer circumference portion of the solar cell 101 without having any apexes. Hence, the dividing groove 8a has a configuration in which the linear grooves formed linearly and the curved grooves formed curvedly are alternately coupled to one another. Note that, in this embodiment, the "apex" refers to a point where two straight lines intersect each other.

Moreover, a shortest distance between each of the curved grooves and the outer circumference portion of the solar cell 101 is smaller than a shortest distance between each of the linear grooves and the outer circumference portion of the solar cell 101. Specifically, the curved grooves form an outermost portion of the dividing groove 8a. In other words, the curved grooves have a protruding shape toward the outside of the dividing groove 8a.

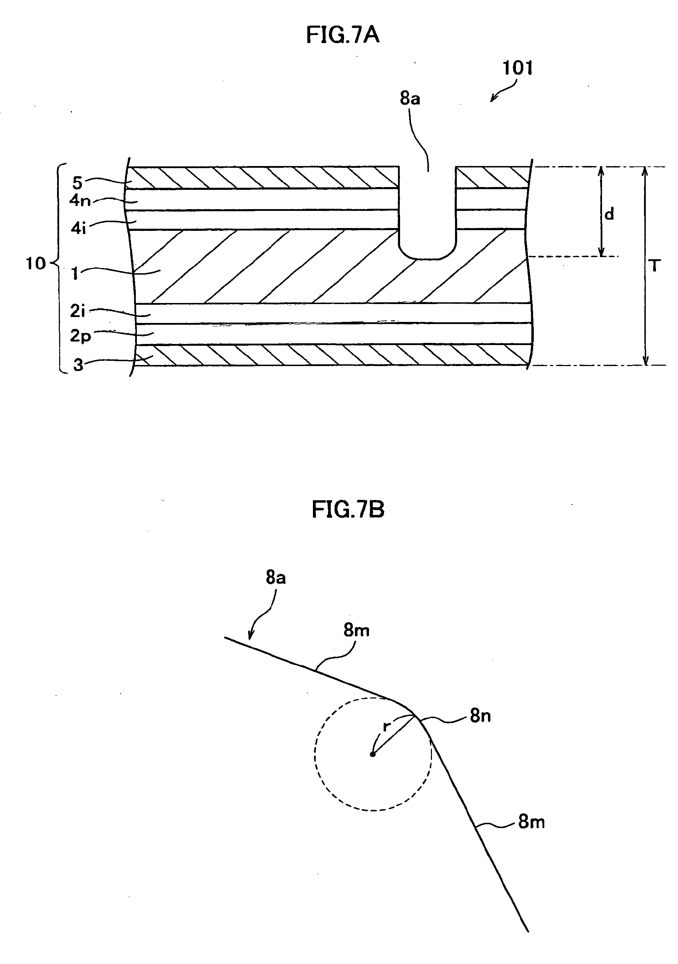

FIG. 7A is an enlarged cross-sectional view of a portion α in FIG. 5B. As shown in FIG. 7A, with respect to a thickness T (approximately 140 µm to 190 µm) of the photoelectric conversion part 10, the dividing groove 8a as one of the dividing grooves 8 has a depth d (approximately 60 µm to 80 µm) from the back surface side of the photoelectric conversion part 10. The depth d of the dividing groove 8 just needs to have a magnitude enough to reach the n-type single crystal silicon substrate 1 in a thickness direction of the photoelectric conversion part 10. Moreover, it is preferable that the depth d of the dividing groove 8 should not reach the p-type amorphous silicon layer 2p.

FIG. 7B is an enlarged view of the portion α in FIG. 5B. The dividing groove 8a is formed in such a manner that two linear grooves 8m are coupled to each other by one curved groove 8n. There are no limitations on a curvature radius r of the curved groove 8n, and the curvature radius r can be set within a range where the moving speed of the laser beam is maintained substantially.

### <Function and Effect>

The method for manufacturing a solar cell according to this embodiment includes: forming the dividing groove 8a that reaches the n-type single crystal silicon substrate 1 in the thickness direction of the photoelectric conversion part 10; and fracturing the solar cell 101 (the photoelectric conversion part 10) along the dividing groove 8a, wherein the dividing groove 8a is formed continuously in the inside of the outer circumference portion of the solar cell 101 (the photoelectric conversion part 10).

As described above, since the dividing groove 8a is formed continuously, the number of portions onto which the laser beam is irradiated twice is small. Accordingly, an apprehension that the semiconductor junction may be broken is reduced. Moreover, since the dividing groove 8a is formed in the inside of the outer circumference portion of the photoelectric conversion part 10, the solar cell 101 can fabricate the photoelectric conversion part 10 by using portions of the n-type single crystal silicon substrate 1, in which the number of crystal faults is small. Hence, the solar cell 101 can obtain good characteristics. Moreover, the collecting electrodes (the light receiving surface-side collecting electrodes 6, and the back surface-side collecting electrodes 7) are formed on the photoelectric conversion part 10, and thereafter, the dividing groove 8a is formed, and the photoelectric conversion part 10 is fractured. Accordingly, good productivity can be obtained.

Moreover, in accordance with the method for manufacturing a solar cell according to this embodiment, the dividing groove 8a is formed without having any apexes.

Hence, it is not necessary to perform the direction change of the laser beam, which is for the purpose of forming the apexes on the outer circumference portion of the solar cell 101, as shown in FIG. 1. As a result, a time for the step of forming the dividing grooves can be shortened, and the productivity of the solar cell 101 can be enhanced.

Moreover, it is preferable that the dividing groove 8a be composed of the linear grooves 8m and the curved grooves 8n, and that the shortest distance between each of the curved grooves 8n and the outer circumference portion of the solar cell 101 be smaller than the shortest distance between each of the linear grooves 8m and the outer circumference portion of the solar cell 101.

As described above, the outermost portion of the dividing groove 8a is composed of the curved grooves 8n, whereby an area of a region removed along the dividing groove 8a can be reduced. Hence, utilization efficiency of the n-type single crystal silicon substrate 1 can be enhanced.

In such a way as described above, in accordance with the method for manufacturing a solar cell according to this embodiment, the dividing grooves can be formed in a short time, and the characteristics of the solar cell can be enhanced.

### <Other Embodiments>

Although the present invention has been described by the above-described embodiment, it should not be understood that the description and the drawings, which form a part of this disclosure, limit the present invention. From this disclosure, a variety of alternative embodiments, examples and operation technologies will be obvious for those skilled in the art.

For example, though the n-type single crystal silicon substrate 1 is used in the above-described embodiment, a p-type single crystal silicon substrate can be used. In this case, an i-type amorphous silicon layer and an n-type amorphous silicon layer just need to be sequentially stacked on a light receiving surface side of the p-type single crystal silicon substrate, and an i-type amorphous silicon layer and a p-type amorphous silicon layer just need to be sequentially stacked on a back surface side of the p-type single crystal silicon substrate.

Moreover, the i-type amorphous silicon layer and the n-type amorphous silicon layer may be sequentially stacked on the light receiving surface side of the n-type single crystal silicon substrate, and the i-type amorphous silicon layer and the p-type amorphous silicon layer may be sequentially stacked on the back surface side of the n-type single crystal silicon substrate.

Moreover, though the n-type single crystal silicon substrate 1 is used in the above-described embodiment, a common semiconductor substrate such as a polycrystal silicon substrate and a compound semiconductor substrate can be used.

Moreover, though the description has been made of the case where the photoelectric conversion part 10 has the semiconductor pin junction using the n-type single crystal silicon substrate 1 in the above-described embodiment, the photoelectric conversion part 10 may have a semiconductor pn junction using the semiconductor substrate. In this case, p-type or n-type dopant is doped into a surface of an n-type or p-type crystalline semiconductor substrate, whereby the pn junction can be formed.

Moreover, though the description has been made of the method for manufacturing the solar cell 101 by using the n-type single crystal silicon substrate 1 in the above-described embodiment, the present invention can also be applied to a semiconductor substrate of other than the solar cell.

Moreover, though the light receiving surface-side collecting electrodes 6 and the back surface-side collecting electrodes 7 are formed into the comb shape in the above-described embodiment, the forming pattern of these can be designed arbitrarily.

Moreover, though the circular solar cell 101 is fractured to be thereby divided into four in the above-described embodiment, there are no limitations on the shape of the solar cells 101 after being fractured. Hence, the forming pattern of the dividing grooves 8 is not limited to that described in the above-described embodiment, either. For example, each of such curved portions may be formed of a plurality of curved lines different in curvature radius.

## Claims

1. A method for manufacturing a solar cell, comprising:
forming a photoelectric conversion part (10) that includes a semiconductor substrate (1);
forming collecting electrodes (6, 7) on the photoelectric conversion part (10);
forming a dividing groove (8) that reaches the semiconductor substrate (1) in a thickness direction of the photoelectric conversion part (10); and
fracturing the photoelectric conversion part (10) along the dividing groove (8),
wherein the dividing groove (8) is formed by a laser beam that repeats alternately a linear movement and a curved movement.

2. The method for manufacturing solar cell according to claim 1,
wherein the dividing groove (8) is composed of linear grooves and curved grooves, and
a shortest distance between each of the curved grooves and the outer circumference portion of the photoelectric conversion part (10) is smaller than a shortest distance between each of the linear grooves and the outer circumference portion of the photoelectric conversion part (10).

## Patentansprüche

1. Verfahren zum Herstellen einer Solarzelle, umfassend:
Ausbilden eines photoelektrischen Umwandlungsteils (10), der ein Halbleitersubstrat (1) umfasst:
Ausbilden von Sammelelektroden (6, 7) auf dem photoelektrischen Umwandlungsteil (10);
Ausbilden einer Trennnut (8), die das Halbleitersubstrat (1) in einer Dickenrichtung des photoelektrischen Umwandlungsteils (10) erreicht;
Brechen des photoelektrischen Umwandlungsteils (10) entlang der Trennnut (8),
wobei die Trennnut (8) durch einen Laserstrahl ausgebildet wird, der abwechselnd eine lineare Bewegung und eine gekrümmte Bewegung wiederholt.

2. Verfahren zum Herstellen einer Solarzelle nach Anspruch 1,
wobei die Trennnut (8) lineare Nuten und gekrümmte Nuten umfasst, und
wobei der kürzeste Abstand zwischen jeder der gekrümmten Nuten und dem äußersten Umfangsabschnitt des photoelektrischen Umwandlungsteils (10) kleiner ist als der kürzeste Abstand zwischen jeder der linearen Nuten und dem äußersten Umfangsabschnitt des photoelektrischen Umwandlungsteils (10).

## Revendications

1. Procédé pour fabriquer une cellule solaire, comprenant :
la formation d'une partie de conversion photoélectrique (10) qui comprend un substrat semi-conducteur (1) ;
la formation d'électrodes de collecte (6, 7) sur la partie de conversion photoélectrique (10) ;
la formation d'une rainure de séparation (8) qui atteint le substrat semi-conducteur (1) dans une direction d'épaisseur de la partie de conversion photoélectrique (10) ; et
la fracture de la partie de conversion photoélectrique (10) le long de la rainure de division (8),
dans lequel la rainure de division (8) est formée par un faisceau laser qui répète alternativement un déplacement linéaire et un déplacement incurvé.

2. Procédé pour fabriquer une cellule solaire selon la revendication 1,
dans lequel la rainure de division (8) est composée de rainures linéaires et de rainures incurvées, et
une distance la plus courte entre chacune des rainures incurvées et la partie de circonférence extérieure de la partie de conversion photoélectrique (10) est inférieure à une distance la plus courte entre chacune des rainures linéaires et la partie de circonférence extérieure de la partie de conversion photoélectrique (10).
